(19) Europäisches Patentamt
European Patent Office
Office européen des brevets

(11) **EP 0 988 688 B1**

(12) **EUROPÄISCHE PATENTSCHRIFT**

(45) Veröffentlichungstag und Bekanntmachung des Hinweises auf die Patenterteilung:
**10.10.2001   Patentblatt 2001/41**

(21) Anmeldenummer: **98929207.3**

(22) Anmeldetag: **08.04.1998**

(51) Int Cl.$^7$: **H02M 3/00**

(86) Internationale Anmeldenummer:
**PCT/DE98/00995**

(87) Internationale Veröffentlichungsnummer:
**WO 98/58438 (23.12.1998 Gazette 1998/51)**

(54) **INTEGRIERTE VOLLBRÜCKENSCHALTUNG MIT VIER TRANSISTOREN**

INTEGRATED COMPLETE BRIDGE CIRCUIT WITH FOUR TRANSISTORS

MONTAGE EN PONT COMPLET INTEGRE A QUATRE TRANSISTORS

(84) Benannte Vertragsstaaten:
**DE FR GB IT**

(30) Priorität: **18.06.1997   DE 19725835**

(43) Veröffentlichungstag der Anmeldung:
**29.03.2000   Patentblatt 2000/13**

(73) Patentinhaber: **Infineon Technologies AG**
**81669 München (DE)**

(72) Erfinder:
• **HORCHLER, Wolfgang**
**D-83026 Rosenheim (DE)**

• **MÜLLER, Reinhard**
**D-81679 München (DE)**

(74) Vertreter: **Zedlitz, Peter, Dipl.-Inf. et al**
**Patentanwalt,**
**Postfach 22 13 17**
**80503 München (DE)**

(56) Entgegenhaltungen:
**US-A- 4 639 794          US-A- 4 989 114**

EP 0 988 688 B1

**Beschreibung**

Die Erfindung betrifft eine integrierte Vollbrückenschaltung mit vier Transistoren, welche paarweise in Reihe zu jeweils einer Halbbrücke geschaltet sind und jeweils über Widerstandselemente an Bezugspotential und eine von zwei innerhalb eines Gehäuses getrennten Versorgungsklemmen geschaltet sind, wobei die über Widerstandselemente an Versorgungspotential geschalteten Transistoren jeweils an ihren Steueranschlüssen einen vorgeschalteten Treibertransistor vom komplementären Typ aufweisen.

Solche integrierten Vollbrückenschaltungen sind mittlerweile allgemein bekannt. Aus der US 4,989,114 ist eine integrierte Vollbrückenschaltung mit vier Transistoren bekannt, die jeweils über in den Pfaden angeordneten Widerstandselemente an die Versorgungsklemmen angeschlossen sind. Die Transistoren der oberen Brückenhälfte weisen jeweils an ihren Steueranschlüssen einen vorgeschalteten Treibertransistor vom komplementären Typ auf. Aus der US 4,639,794 ist eine Treiberschaltung für eine Brückenschaltung bekannt, bei der ein Treibertransistor an die Steueranschlüsse von zwei Transistoren der Brückenschaltung, die diagonal angesteuert sind, angeschlossen ist. Damit werden mit einem Treibertransistor zwei Transistoren der Brückenschaltung angesteuert.

Weitere Beispiele dieser integrierten Schaltungskomponenten sind unter anderem TLE 4203 (Siemens) und L9937 (SGS-Thomson Microelectronics).

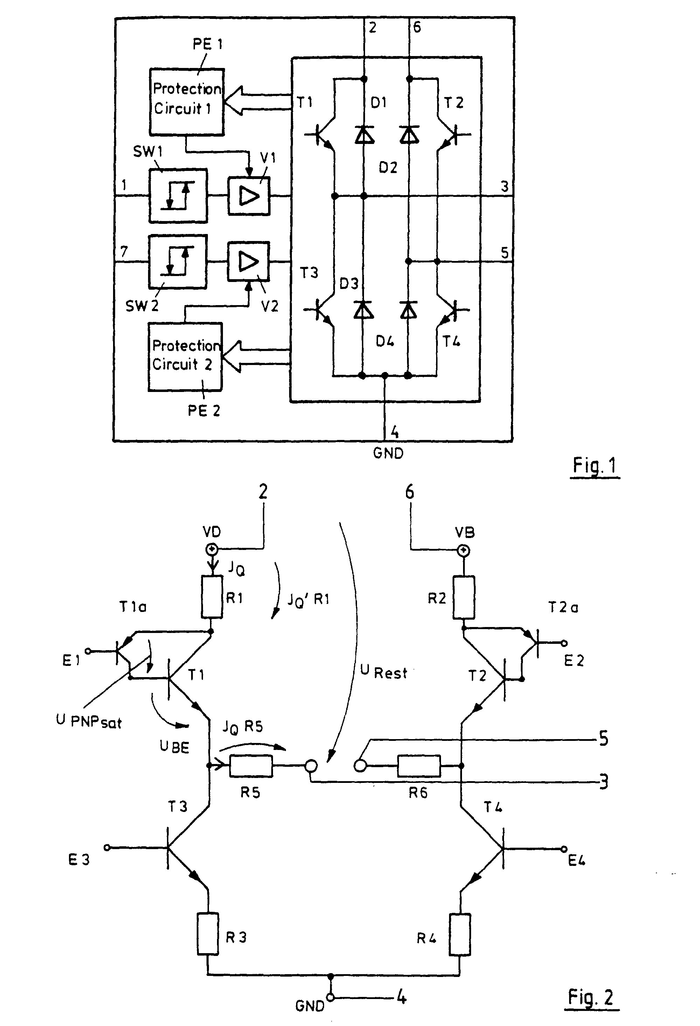

Das Blockschaltbild des integrierten Bausteins TLE 4203 ist in Fig. 1 dargestellt. Der Baustein verfügt insgesamt über sieben zugängliche Anschlüsse, die wie folgt belegt sind:

1: Steuereingang A
2: Versorgungsspannung VD
3: Ausgang A
4: Bezugspotential
5: Ausgang B
6: Versorgungsspannung VB
7: Steuereingang B

Zwischen die Ausgänge 3, 5 kann beispielsweise ein Motor angeschlossen werden. Die Anschlüsse 2, 6 werden z. B. an den positiven Pol einer Autobatterie und der Anschluß 4 an den negativen Pol dieser Batterie geklemmt. Eine geeignete Steuerschaltung stellt an den Anschlüssen 1, 7 zueinander invertierende Steuersignale zur Verfügung, so daß der an die Anschlüsse 3, 5 angeschlossene Motor nach links oder rechts dreht.

Der integrierte Schaltkreis weist eine Vollbrückenschaltung auf, die im vorliegenden Blockschaltbild schematisch durch die beiden parallel geschalteten Halbbrücken mit den NPN-Bipolartransistoren T1, T3 und T2, T4 gebildet sind. Parallel zu den Laststrecken dieser vier Bipolartransistoren T1 ... T4 sind Freilaufdioden D1 ... D4 geschaltet. Im Einzelnen ist der Kollektoranschluß des Transistors T1 und der Kathodenanschluß der Freilaufdiode D1 an den Anschluß 2 für Versorgungsspannung VD geschaltet. Der Emitteranschluß des Transistors T3 und der Anodenanschluß der zugehörenden Freilaufdiode D3 ist dagegen an den Anschluß 4 für Bezugspotential GND geschaltet. Der Verbindungspunkt zwischen dem Emitteranschluß des Transistors T1, dem Anodenanschluß der Freilaufdiode D1, dem Kollektoranschluß des Transistors T3 und dem Kathodenanschluß der Freilaufdiode D3 ist mit dem Anschluß 3 des Ausgangs A der integrierten Schaltung in Verbindung. In ähnlicher Weise sind die Transistoren T2, T4 und die zugehörenden Freilaufdioden D2, D4 zwischen die Anschlüsse 6 und 4 der integrierten Schaltung geschaltet. Deren Verbindungspunkt ist mit dem Anschluß 5 für den Ausgang B in Kontakt. Des weiteren verfügt der integrierte Schaltkreis TLE 4203 über zwei Schutzeinrichtungen PE1, PE2. Zwischen den Anschluß 1 für den Steuereingang A und die Vollbrückenschaltung ist ein Schwellwertschalter SW1 mit nachgeschaltetem Verstärker V1 geschaltet. In ähnlicher Weise ist zwischen den Anschluß 7 und die Vollbrückenschaltung ein Schwellwertschalter SW2 mit nachgeschaltetem Verstärker V2 geschaltet.

In Fig. 2 ist der die Vollbrückenschaltung beinhaltende Schaltungsteil des Blockschaltbildes von Fig. 1 vergrößert und detaillierter dargestellt. Die bereits bekannten Bezugszeichen stehen für die schon erläuterten Komponenten. Die Schaltungsanordnung von Fig. 2 ist um Widerstandselemente R1 ... R6 ergänzt, die im Wesentlichen durch die ohmschen Widerstandswerte von Bonddrähten vorgegeben sind. Die Widerstandswerte liegen zwischen etwa 30 und 120 m . Diese Bonddrähte sind notwendig, um die Klemmen des integrierten Chips mit den Anschlußklemmen des Gehäuses, das beispielsweise ein Dual-Inline-Gehäuse sein kann, zu verbinden. Im Einzelnen sind diese in Form von Bonddrähten realisierten Widerstandselemente wie folgt verschaltet. Das erste Widerstandselement R1 liegt zwischen dem Kollektoranschluß des Transistors T1 und dem Anschluß 2 für Versorgungsspannung VD. Das zweite Widerstandselement R2 liegt zwischen dem Kollektoranschluß des Transistors T2 und dem Anschluß 6 für Versorgungsspannung VB. Das dritte Widerstandselement R3 ist zwischen den Emitteranschluß des Transistors T3 und den Anschluß 4 für Bezugspotential GND geschaltet, während das Widerstandselement R4 zwischen den Emitteranschluß des Transistors T4 und diesen Anschluß 4 geschaltet ist. Zwischen den Anschluß 3 und den Verbindungspunkt des Emitteranschlusses des Transistors T1 und des Kollektoranschlusses des Transistors T3 ist das fünfte Widerstandselement R5 und zwischen den Anschluß 5 und dem Verbindungspunkt des Emitteranschlusses des Transistors T2 und des Kollektoranschlusses des Transistors T4 das Widerstandselement R6 geschaltet.

Die erwähnten Transistoren T1 ... T4 sind jeweils NPN-Bipolartransistoren. Wie in Fig. 2 dargestellt, sind die beiden oberen Transistoren T1, T2, deren Kollektoranschlüsse über die Widerstandselemente R1, R2 jeweils an Versorgungsspannung VD bzw. VB liegen, als "Quasi-PNP-Transistoren" geschaltet, d. h., daß diese Transistoren T1, T2 ihren Basisstrom jeweils an deren Basisanschlüssen über vorgeschaltete PNP-Treibertransistoren T1a bzw. T2a beziehen. Hierfür ist der Treibertransistor T1a mit seinem Kollektoranschluß an den Basisanschluß des Transistors T1 und mit seinen Emitteranschluß an den Verbindungspunkt zwischen Widerstandselement R1 und Kollektoranschluß des Transistors T1 geschaltet. Der Steueranschluß des Treibertransistors T1a ist mit einer Eingangsklemme E1 der Vollbrückenschaltung in Kontakt.

In ähnlicher Weise ist der Treibertransistor T2a an den Transistor T2 geschaltet. Der Emitteranschluß des Treibertransistors T2a ist mit dem Kollektoranschluß des Transistors T2 und der Kollektoranschluß des Treibertransistors T2a mit dem Basisanschluß des Transistors T2 in Verbindung. Der Basisanschluß des Treibertransistors T2a ist mit einem Eingangsanschluß E2 der Vollbrückenschaltung in Kontakt. Die beiden Treibertransistoren T1a, T2a sind vom komplementären Typ der Transistoren T1, T2, hier also PNP-Bipolartransistoren.

Die Basisanschlüsse der Transistoren T3, T4 sind mit jeweils einer Eingangsklemme E3, E4 der Vollbrückenschaltung in Verbindung.

Wie aus den Figuren 1 und 2 erkennbar, wird bei den integrierten Schaltkreisen häufig die Kontaktierung der Leistungsanschlüsse, hier der Kollektoranschlüsse der Transistoren T1 und T2, über getrennte Bonddrähte, hier also die getrennten Widerstandselemente R1, R2, an Versorgungsspannung durchgeführt. An die beiden Anschlüsse 2, 6 ist beispielsweise +12 Volt einer Autobatterie angelegt. Die beiden Anschlüsse 2, 6 sind zum einen layouttechnisch bedingt, da hierdurch eine gute Symmetrie des integrierten Schaltkreises erreicht werden kann, und zum anderen wird durch die beiden Leitungsanschlüsse 2, 6 die Strombelastung der beiden Widerstandselemente R1, R2 gesenkt. Das Zusammenschalten der beiden Anschlüsse 2, 6 erfolgt dann extern.

Problematisch bei diesen bekannten Brückenschaltungen ist die im Betrieb entstehende Verlustleistung. Die Verlustleistung ist nämlich dafür verantwortlich, daß sich die integrierten Schaltkreise, in denen sich solche Vollbrückenschaltungen befinden, teilweise beträchtlich erwärmen.

Ziel der Erfindung ist, die eingangs genannte Vollbrückenschaltung so weiterzubilden, daß deren Verlustleistung gegenüber den bekannten Vollbrückenschaltungen deutlich reduziert wird.

Dieses Ziel wird bei der eingangs genannten Vollbrückenschaltung dadurch erreicht, daß die Laststrecke jedes Treibertransistors mit einem Anschluß an den Steueranschluß des jeweils nachgeschalteten Transistors und mit einem anderen Anschluß an den Anschluß für Versorgungsspannung der jeweils anderen Halbbrückenschaltung geschaltet ist. Im Vergleich zu den bekannten Vollbrückenschaltungen mit Treibertransistoren sind die Lastanschlüsse der Treibertransistoren zueinander gekreuzt ausgeführt und an die jeweils anderen Halbbrücken geschaltet. Vorteilhaft bei dieser Lösung ist die Tatsache, daß bei leitendem Treibertransistor und nachgeschaltetem leitendem Transistor nur der Treiberstrom über das an die Versorgungsklemme der anderen Halbbrückenschaltung geschaltete Widerstandselement, also den Bonddraht, fließt. Die Verlustleistung kann durch diese erfindungsgemäße Lösung um etwa 5 bis 10 % reduziert werden.

In einer Weiterbildung der Erfindung sind die Transistoren als Bipolartransistoren ausgebildet, wobei die Treibertransistoren vorzugsweise PNP-Transistoren sind.

Die Widerstandselemente sind vorzugsweise Bonddrähte aus Gold oder Aluminium mit einem Widerstandswert von etwa 30 bis 120 mΩ. Die gesamte Vollbrückenschaltung kann erfindungsgemäß u. a. in ein Dual-Inline-Gehäuse, ein Dual-Small-Outline-Gehäuse, ein Transistor-Outline-Gehäuse oder ein Single-Inline-Package-Gehäuse integriert sein.

Die integrierte Vollbrückenschaltung nach der Erfindung wird nachfolgend im Zusammenhang mit einer weiteren Figur näher erläutert. Es zeigen:

Figur 1    das Blockschaltbild der bereits bekannten integrierten Vollbrückenschaltung TLE 4203,

Figur 2    einen Ausschnitt der integrierten Schaltung von Figur 1, und

Figur 3    die Schaltungsanordnung der Vollbrückenschaltung nach der Erfindung mit gekreuzten Zuleitungen der Treibertransistoren.

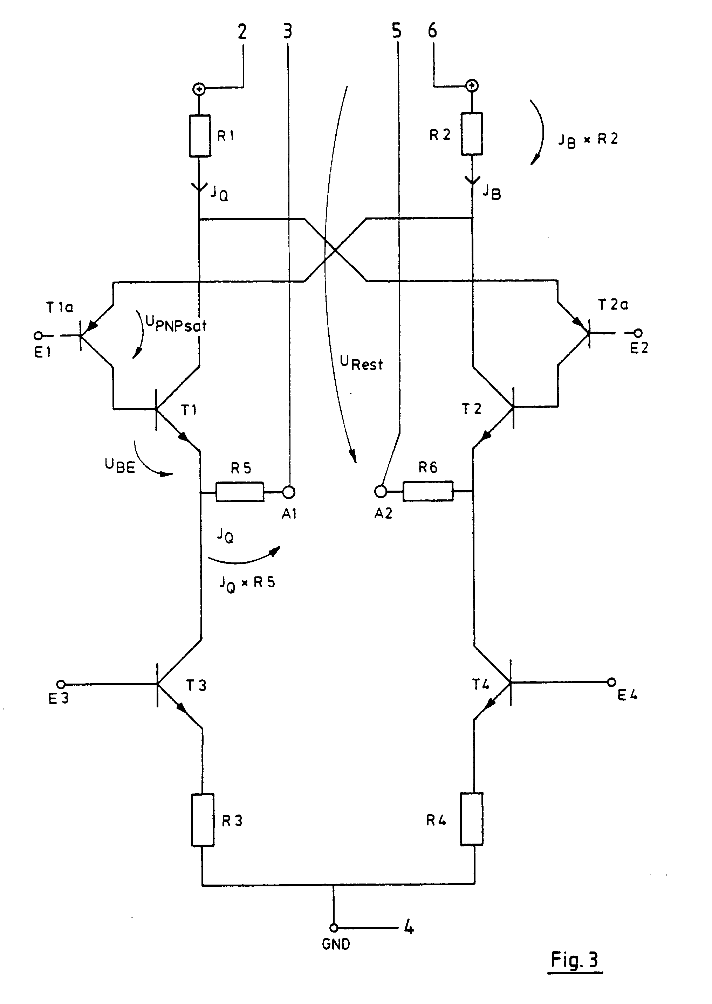

Die Schaltungsanordnung von Fig. 3 entspricht weitgehend der in Fig. 2 dargestellten Vollbrückenschaltung. Die bereits bekannten Bezugszeichen werden für die gleichen Schaltungskomponenten weiter verwendet.

Im Gegensatz zur Schaltungsanordnung von Fig. 2 sind jedoch jetzt die Emitteranschlüsse der beiden Treibertransistoren T1a, T2a zueinander gekreuzt an die jeweils anderen Halbbrücken geschaltet. Im Einzelnen ist der Emitteranschluß des PNP-Treibertransistors T1a an den Verbindungspunkt zwischen dem Kollektoranschluß des Transistors T2 und des Widerstandselementes R2 geschaltet. Der Emitteranschluß des anderen PNP-Treibertransistors T2a ist dagegen mit dem Verbindungspunkt, der zwischen dem Widerstandselement R1 und dem Kollektoranschluß des Transistors T1 liegt, verbunden.

Hinsichtlich der reduzierten Verlustleistung bei dieser in Fig. 3 dargestellten Vollbrückenschaltung ergibt sich folgendes.

Es sei angenommen, daß die Transistoren T1a, T1 und T4 aufgrund entsprechender Steuersignale an den Eingangsklemmen E1, E4 leiten. Die übrigen Transistoren T2, T2a und T3 sperren. Zwischen die Anschlüsse 3 und 5 ist ein elektrischer Verbraucher, z. B. ein Motor, angeschlossen.

Die sich zwischen den beiden Anschlüssen 6 und 3 einstellende Verlustspannung ist durch folgende Formel bestimmt:

$$I_B \times R2 + U_{PNPsat} + U_{BE} + I_Q \times R5 = U_{REST}.$$

Hierbei bedeuten $I_B$ = Steuerstrom, $I_Q$ = Laststrom, wobei $I_Q$ 100 x $I_B$, $U_{PNPsat}$ = Sättigungsspannung des Treibertransistors T1a, $U_{BE}$ = Emitterspannung des Transistors T1.

Geht man davon aus, daß der Steuerstrom $I_B$ etwa 100 mal kleiner als der Laststrom $I_Q$ ist, so ist der Term $I_B \times R2$ vernachlässigbar.

Es gilt dann für die Verlustspannung:

$$U_{REST} = U_{PNPsat} + U_{BE} + I_Q \times R5.$$

Vergleicht man hierzu die in einem oberen Zweig der Brückenschaltung von Fig. 2 auftretende Verlustleistung, so ergibt sich folgendes:

$$U_{REST} = I_Q \times R1 + U_{PNPsat} + U_{BE} + I_Q \times R5.$$

Vergleicht man die in den beiden Schaltungen gemäß Figuren 2 und 3 auftretenden Verlustspannungen in dem jeweils oben leitenden Schaltungsteil, so zeigt sich deutlich, daß bei der Schaltung gemäß Fig. 3 die Verlustleistung nahezu um den Term $I_Q \times R1$ reduziert ist. Eine geringere Verlustleistung des gesamten Schaltkreises ist die Folge.

Bezugszeichenliste

1    Steuereingang A
2    Versorgungsspannung VD
3    Ausgang A
4    Bezugspotential GND
5    Ausgang B
6    Versorgungsspannung VB
7    Steuereingang B
11   T1 ... T4 Transistoren
12   T1a, T2a Treibertransistoren
14   PE1, PE2 Schutzeinrichtungen
16   SW1, SW2 Schwellwertschalter
18   V1, V2 Verstärker

20   D1 ... D4 Freilaufdioden
24   R1 ... R6 Widerstandselemente
26   E1 ... E4 Eingangsklemmen

**Patentansprüche**

1.   Integrierte Vollbrückenschaltung mit vier Transistoren (T1, T2, T3, T4), welche paarweise in Reihe zu jeweils einer Halbbrücke geschaltet sind und jeweils über Widerstandselemente (R3, R4) an Bezugspotential (GND) und eine von zwei innerhalb eines Gehäuses getrennten Versorgungsklemmen (VD, VB) geschaltet sind, wobei die über Widerstandselemente (R1, R2) geschalteten Transistoren (T1, T2) jeweils an ihren Steueranschlüssen einen vorgeschalteten Treibertransistor (T1a, T2a) vom komplementären Typ aufweisen,
**dadurch gekennzeichnet,**
**daß** die Laststrecke jedes Treibertransistors (T1a, T2a) jeweils mit einem Anschluß an den Steueranschluß des nachgeschalteten Transistors (T1, T2) und mit einem anderen Anschluß an den Verbindungspunkt zwischen dem Widerstandselement (R2, R1) und den Transistor (T2, T1) der jeweils anderen Halbbrückenschaltung geschaltet ist.

2.   Integrierte Vollbrückenschaltung nach Anspruch 1,
**dadurch gekennzeichnet,**
**daß** sämtliche Transistoren (T1, T1a, T2, T2a, T3 und T4) jeweils als Bipolartransistoren ausgebildet sind.

3.   Integrierte Vollbrückenschaltung nach Anspruch 2,
**dadurch gekennzeichnet,**
**daß** die Treibertransistoren (T1a, T2a) PNP-Bipolartransistoren und die übrigen Transistoren (T1 ... T4) NPN-Bipolartransistoren sind.

4.   Integrierte Vollbrückenschaltung nach einem der Ansprüche 1 bis 3,
**dadurch gekennzeichnet,**
**daß** die Widerstandselemente durch Bonddrähte realisiert sind, welche Anschlußklemmen eines integrierten Schaltkreises mit Klemmen eines integrierten Chips, auf den die Transistoren (T1 ... T4) und Treibertransistoren (T1a, T2a) integriert sind, verbinden.

5.   Integrierte Vollbrückenschaltung nach Anspruch 4,
**dadurch gekennzeichnet,**
**daß** die Bonddrähte aus Gold oder Aluminium bestehen.

6.   Integrierte Vollbrückenschaltung nach einem der Ansprüche 1 bis 5,
**dadurch gekennzeichnet,**
**daß** die Widerstandselemente jeweils einen Widerstandswert von etwa 30 bis 120 mΩ aufweisen.

7. Integrierte Vollbrückenschaltung nach einem der Ansprüche 1 bis 6,
**dadurch gekennzeichnet,**
**daß** diese in ein Dual-Inline-Gehäuse, ein Dual-Small-Outline-Gehäuse, ein Transistor-Outline-Gehäuse oder ein Single-Inline-Package-Gehäuse integriert ist.

**Claims**

1. Integrated full-bridge circuit with four transistors (T1, T2, T3, T4) which are connected pairwise in series to form a respective half-bridge and are respectively connected via resistance elements (R3, R4) to reference-earth potential (GND) and one of two supply terminals (VD, VB) that are isolated within a housing, the transistors (T1, T2) connected via resistance elements (R1, R2) respectively having, at their control terminals, an upstream-connected driver transistor (T1a, T2a) of the complementary type,
**characterized**
**in that** the load path of each driver transistor (T1a, T2a) is respectively connected by one terminal to the control terminal of the downstream-connected transistor (T1, T2), and by another terminal to the junction point between the resistance element (R2, R1) and the transistor (T2, T1) of the respective other half-bridge circuit.

2. Integrated full-bridge circuit according to Claim 1,
**characterized**
**in that** all of the transistors (T1, T1a, T2, T2a, T3 and T4) are designed as bipolar transistors in each case.

3. Integrated full-bridge circuit according to Claim 2,
**characterized**
**in that** the driver transistors (T1a, T2a) are PNP bipolar transistors and the remaining transistors (T1 ... T4) are NPN bipolar transistors.

4. Integrated full-bridge circuit according to one of Claims 1 to 3,
**characterized**
**in that** the resistance elements are realized by bonding wires which connect terminals of an integrated circuit to terminals of an integrated chip on which the transistors (T1 ... T4) and driver transistors (T1a, T2a) are integrated.

5. Integrated full-bridge circuit according to Claim 4,
**characterized**
**in that** the bonding wires are composed of gold or aluminium.

6. Integrated full-bridge circuit according to one of Claims 1 to 5,
**characterized**
**in that** the resistance elements each have a resistance of about 30 to 120 mΩ.

7. Integrated full-bridge circuit according to one of Claims 1 to 6,
**characterized**
**in that** it is integrated in a dual inline package, a dual small outline package, a transistor outline package or a single inline package.

**Revendications**

1. Circuit en pont complet intégré à quatre transistors (T1, T2, T3, T4) qui sont branchés par paire en série en un demi-pont et qui sont branchés respectivement par l'intermédiaire d'élément (R3, R4) de résistance sur le potentiel (GND) de référence et sur l'une de deux bornes (VD, VB) séparées à l'intérieur d'un boîtier, les transistors (T1, T2) branchés par l'intermédiaire des éléments (R1, R2) de résistance comportant chaque fois sur leur borne de commande un transistor (T1a, T2a) d'attaque en amont du type complémentaire,
**caractérisé en ce que** la section de charge de chaque transistor (T1a, T2a) d'attaque est branchée respectivement par une borne sur la borne de commande du transistor (T1, T2) en aval et par une autre borne sur le point de liaison entre l'élément (R2, R1) de résistance et le transistor (T2, T1) de respectivement l'autre circuit en demi-pont.

2. Circuit en pont complet intégré suivant la revendication 1, **caractérisé en ce que** tous les transistors (T1, T1a, T2, T2a, T3 et T4) sont réalisés respectivement en transistor bipolaire.

3. Circuit en pont complet intégré suivant la revendication 2, **caractérisé en ce que** les transistors (T1a, T2a) d'attaque sont des transistors bipolaires PNP et les transistors (T1 ... T4) restant des transistors bipolaires NPN.

4. Circuit en pont complet intégré suivant l'une des revendications 1 à 3, **caractérisé en ce que** les éléments de résistance sont réalisés par des fils de liaison qui relient des bornes de raccordement d'un circuit intégré à des bornes d'une puce intégrée sur laquelle les transistors (T1 ... T4) et les transistors (T1a, T2a) d'attaque sont intégrés.

5. Circuit en pont complet intégré suivant la revendication 4, **caractérisé en ce que** les fils de liaison sont en or ou en aluminium.

**6.** Circuit en pont complet intégré suivant l'une des revendications 1 à 5, **caractérisé en ce que** les éléments de résistance ont chaque fois une valeur de résistance d'environ 30 à 120 mΩ.

**7.** Circuit en pont complet intégré suivant l'une des revendications 1 à 6, **caractérisé en ce que** ce circuit est intégré à un boîtier dual-inline, un boîtier dual-small-outline, un boîtier transistor outline ou un boîtier single-inline-package.

Fig. 1

Fig. 2

Fig. 3